# EUROPEAN PATENT APPLICATION

(11) **EP 1 562 295 A1**
(43) Date of publication of application: **10.08.2005**
(21) Application number: 04250676.6
(22) Date of filing: 09.02.2004
(51) Int. Cl.: H03M 7/30, H04L 27/38, H03M 13/27

(54) **A method to reduce the memory requirement of the deinterleaver within a digital audio broadcast radio receiver using data compression**

(71) Applicant: Matsushita Electric Industrial Co., Ltd., Kadoma-shi, Osaka-fu 571-8501 (JP)
(72) Inventor: Bell, Stewart John Hamish, Oxfordshire RG9 3BZ (GB); Wong, Danny Yuk Kun, Happy Valley (HK); Addy, Timothy Paul, Winchester SO23 7DA (GB)
(74) Representative: Dawson, Elizabeth Ann

(57) **Abstract**

In a DAB radio, the memory requirement for the deinterleaver is reduced by compressing the number of confidence bits, e.g. using Vector Quantisation or run-length compression.

## Description

### Background

To counter the adverse effect of bursts of channel interference, the European Digital Audio Broadcasting (DAB) standard (*Radio broadcast system: Digital audio broadcasting to mobile, portable and fixed receivers, ETS 300 401,* European Broadcast Union, revised July 1997) deploys interleaving on convolutional encoded data bits over time. The interleaving time span is exactly 16 Common Interleaved Frames (CIFs), each of which lasts 24ms, i.e. the overall spread in time is about 384ms. In order to recover the original non-interleaved but encoded data, one needs to buffer up the current CIF as well as the previous 15. Each of these 16 CIFs would contribute an equal number of convolutional encoded bits to allow the reconstruction. To enhance the error correcting performance of the Viterbi decoder of the convolutional encoded data, it is common to attach a confidence value to each encoded bit. This composite representation of the encoded data is called a *soft-decision,* which is in contrast to a *hard-decision* representing merely the encoded data bit. Typically for DAB, a soft-decision is 4 bits (1 bit data and 3 bits confidence measure). The use of soft-decisions increases dramatically the amount of buffer storage required for the deinterleaver. By suitably exploiting certain correlations between soft-decisions within the same CIF, a more compact representation can be achieved, and thus the amount of buffer storage can be reduced significantly.

In an ETS 300 401 DAB transmitter, data bits from different logical sources are organised into sub-channels. These sub-channels are each assigned a protection level which controls the amount of channel protection to apply via convolutional encoding. The convolutional encoded data bits to be broadcast are arranged into 24ms groups.

Each of these groups is divided into 16 equal parts. The first part is transferred to a buffer, which has already accumulated 15 similar parts from the preceding 15 x 24ms. The second part is transferred to a second buffer, which has accumulated 14 parts from the preceding 14 x 24ms. The pattern is repeated for the remaining parts. The aggregate of 16 parts from 16 24ms groups is called a Common Interleaved Frame (CIF).

Every 24ms, a CIF is mapped on to a series of symbols, made up of multiple carriers, each of which bears a real and an imaginary component. The actual combination of number of carriers and symbols is determined by the DAB transmission mode. These carriers are further encoded in Differential Quadrature Phase Shift Keying (DQPSK). Finally an Orthogonal Frequency Division Multiplex (OFDM) modulator transforms each symbol into a time domain signal for on-air transmission.

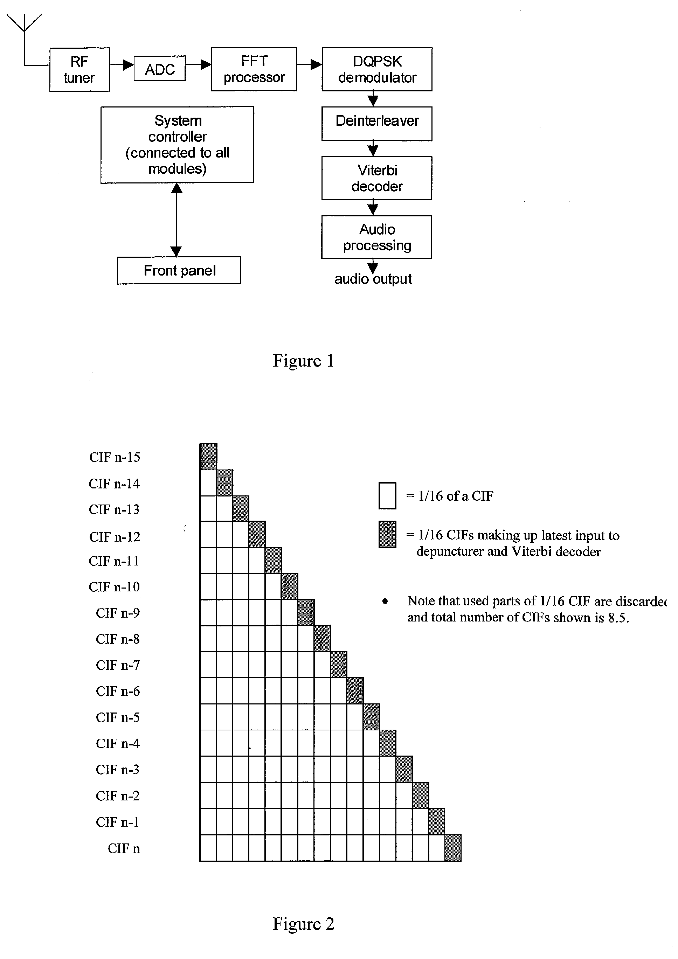

Figure 1 shows the configuration of a typical DAB receiver.

The DAB demodulation process is essentially the inverse of the transmission process. The ensemble of OFDM carriers within each symbol is resolved into the real and imaginary components by means of Fourier Transform and DQPSK demodulation. The resultant complex components are finally quantised to recover the convolutional encoded data bits. Once all convolutional encoded data bits in a given CIF are generated, it can be buffered up.

Recalling the interleaving process which spreads the convolutional encoded data bits from a given 24ms group to 16 CIFs, it is also necessary to buffer up 16 CIFs at the receiver so that the 24ms group can be reconstituted (the process is simply called deinterleaving). Depuncturing and Viterbi decoding are then used to recover the data bits belonging to the sub-channels. Figure 2 depicts the minimal storage requirement.

In order to enhance the error correction performance of the Viterbi decoder, each convolutional encoded bit may be attached with a confidence value. There is a variety of means to generate the confidence values. Typically 3 bits are assigned to each confidence value. Bits inserted by the depuncturer bear null confidence. The combination of the data bit with its confidence value is called a soft-decision, in contrast to a hard-decision which refers solely to the data bit.

The benefit of deploying soft-decision Viterbi decoding is obtained at the expense of a dramatic increase of memory required to store the CIFs. For example, instead of a single bit hard-decision, 4 bits are needed for a soft-decision with a 3-bit confidence value. The increase is four-fold. It is therefore an object of this invention to reduce the amount of memory required to store the CIFs without a resultant increase in errors.

The present invention provides a radio receiver having means for decoding a received data stream to produce a decoded data stream which can be separated into blocks, each block including X data bits and Y confidence bits, where X and Y are integers and the confidence bits indicate the likelihood that the X data bits have been correctly decoded, the receiver further comprising means for compressing the blocks by reducing the number of confidence bits.

The number of confidence bits can be reduced by any suitable compression scheme. Examples include Vector Quantisation (VQ) to be described below and run-length compression. Both compression schemes exploit redundancy which is inherent in the confidence data. For example, in the case of 100% confidence, the confidence bits may be disregarded. More use will be made of the confidence data if the confidence is less.

Run length compression exploits differences between successive confidence values. If successive valves vary greatly there will be no redundancy in the confidence data if but successive confidence values are identical there is redundancy and potential for compression.

A receiver according to the invention may have means for operating more than one compression scheme and means for switching to the most appropriate scheme according to prevailing conditions.

Embodiments of the invention will now be described in more detail by way of example only. In the drawings:
Figure 1 shows the configuration of a typical DAB receiver; and
Figure 2 illustrates the minimal storage requirement for the deinterleaver memory.

The functions of the components of figure 1 are well known in the art and will not be described in detail herein. The components comprise RF tuner 10, analogue to digital converter 11, FFT processor 12, DQPSK demodulator 13, deinterleaver 14, Viterbi decoder 15, and audio processing circuitry 16 supplying the audio output. According to the invention, data from the demodulator 13, in the form of decision bits and confidence bits, is compressed prior to being supplied to the deinterleaver 15. Usually it will be necessary to perform equivalent decompression after deinterleaving for consistency and to avoid the need to modify the subsequent components. As noted above, one of the preferred compression schemes is Vector Quantisation.

Vector Quantisation (VQ) is a technique commonly used to approximate a series of scalar or vector values via the use of one or a combination of indices, in order to achieve a reduction of the storage demand. For a more academic treatment, the textbook *Vector Quantization and Signal Compression* by Allen Gersho and Robert M. Gray is recommended. The underlying principle to make viable VQ is the presence of statistical correlation in the components within and between the series of scalars or vectors.

A VQ scheme requires at least one look-up table which holds a multitude of templates of the scalar or vector values. Using the index to the look-up table (or the so-called codebook), a vector can be recovered. If more than one codebook is used, then complete vectors are recovered by combining selected entries from the respective codebooks. Obviously, for VQ to be of benefit, the total number of bits used by the codebook indices must be less than that of the vector before VQ is applied.

To select the best combination of codebook indices, match criteria need to be defined. There is no single standard technique. Measures such as Euclidean/Hamming distance (mean squared error), Peak-Signal-to-Noise Ratio (PSNR), and non-linear error functions are commonly used.

Similarly the number of codebooks to use is a design choice, a popular choice is the so-called gain-shape VQ. A vector is first normalised to unit magnitude, before it is matched to the appropriate entry in the (shape) codebook filled with unit magnitude vectors, according to the selected distance measure. The normalisation gain is quantised, and it is used jointly with the codebook index to describe an approximation to the original vector.

Finally it should be noted that codebook entries can be either systematically or heuristically derived. Systematic codebooks are constructed by algebraic or similar means. In contrast, a heuristic codebook is derived by analyzing statistics from *training vectors* using a technique known by its discoverers Linde-Buzo-Gray (LBG).

VQ is inherently lossy, i.e. perfect reconstruction is generally impossible. The quality of a VQ scheme depends on
1. The partitioning of the vector input into sub-vectors (e.g. gain and normalised shape).
2. The number of entries within each codebook.
3. The codebook-match criteria.
4. The quality of representation of the training vectors, as compared to the actual vectors in field application.

In the context of applying VQ to the buffering storage of soft-decisions in DAB, it is stipulated that the soft-decisions derived from the same symbol are correlated because of the temporal nature of fading and other types of RF interference.

Fading and many types RF interference are temporal in nature. This leads to corruption of contiguous DAB symbols. Therefore it is likely that the confidence values associated with neighbouring carriers within a given symbol are affected in a correlated manner.

Vector Quantisation can be applied to the confidence values in the soft-decisions of a group of carriers (tagged as a vector) within the same symbol. A judicious choice of the structure of the codebooks, its contents and the number of entries should enable a more compact representation than the vector before VQ is applied.

To apply VQ, a search engine is required. It is capable of evaluating an error score between the original vector of confidence values and each codebook entry, according to certain defined error criteria.

Codebook indices selected by the search engine are stored in the buffering memory of the deinterleaver.

To retrieve an approximation to the original vector, vector entries from the codebook are extracted and reconstructed according to the codebook indices.

A potential side-effect of representing vectors of soft-decision confidence values using vector codebook entries is the automatic suppression of rogue confidence values which do not correlate well with its neighbours within the same group. This is stated under the assumption that the vector codebook entries are only populated with confidence value vectors which do correlate well.

The principle of applying VQ to reduce the amount of buffering memory is applicable to other time-interleaved systems.

### Example

This is an illustrative example of a VQ scheme for compacting the storage of soft-decision confidence values in a typical DAB receiver, which uses 4-bit soft-decisions, i.e. 3bits confidence and 1 data bit.

The number of carriers in a DAB broadcast is either 192, 384, 768 or 1536, as determined by the transmission mode. A reasonable choice for the length of the confidence value vector would be 24. If a vector is very long, the number of codebook entries would be high, and the codebook search becomes an intensive computational task. Each vector is broken down into two parts: an overall gain and a vector of normalised magnitude. As each the magnitude of individual confidence value takes 3 bits to represent, the overall gain must be represented in 3 bits or less. For the normalised vector codebook, 1024 individual entries are possibly sufficient.

The total buffering storage required for each group of 24 soft-decisions before VQ is 24 x 4 = 96 bits. After VQ is applied, the required storage is 24 x 1 + 3 + 10 = 37 bits. The reduction in memory usage is about 60%.

The major cost of deploying a VQ scheme can be found in the extra computation for the codebook search and the extra ROM for holding the codebook entries. Retrieval of a codebook entry and the reconstruction of the vector are relatively trivial.

## Claims

1. A radio receiver having means for decoding a received data stream to produce a decoded data stream which can be separated into blocks, each block including X data bits and Y confidence bits, where X and Y are integers and the confidence bits indicate the likelihood that the X data bits have been correctly decoded, the receiver further comprising means for compressing the blocks by reducing the number of confidence bits.

2. A receiver as claimed in claim 1 in which the error correction means comprise a Viterbi decoder.

3. A receiver as claimed in claim 1 or 2 having means for demodulating the received data stream prior to it being compressed.

4. A receiver as claimed in claim 1, 2 or 3 having means for decoding interleaved data including deinterleaving means arranged to deinterleave the data following compression.

5. A receiver as claimed in claim 4 having means for decompressing the data after it has been deinterleaved.

6. A receiver as claimed in any preceding claim in which the compression means includes means for applying run-length compression to the data blocks.

7. A receiver as claimed in claim 5 or 6 in which the compression means includes means for compressing the data blocks by vector quantisation.

8. A receiver as claimed in claims 6 and 7 including means for switching between different compression means.

9. A receiver as claimed in claim 8 including means for determining which compression means to use and controlling the switching means accordingly.

10. A method of processing data that has been derived from a data stream received via a transmission channel and decoded to produce a decoded data stream including blocks, each block having X data bits and Y confidence bits, where X and Y are integers and the confidence bits indicate the likelihood that the X data bits have been correctly decoded, the method comprising reducing the number of confidence bits using a compression scheme whereby to reduce the memory capacity required for subsequent processing of the data.

11. A method as claimed in claim 10 in which the number of confidence bits is reduced using run length compression.

12. A method as claimed in claim 1 in which the number of confidence bits is reduced using vector quantisation.

13. A method as claimed in claim 10, 11 or 12 in which the compression technique is chosen according to ambient conditions.

14. A method as claimed in any of claims 10 to 13 further comprising correcting errors in the data based on the confidence data.

15. A method as claimed in any of claims 10 to 14 in which the received data is demodulated prior to compressions.

16. A method as claimed in any of claims 10 to 15 for decoding interleaved data in which the data is deinterleaved following compression.

17. A method as claimed in claim 16 in which the data is decompressed after it has been deinterleaved.
